**Europäisches Patentamt**

**European Patent Office**

**Office européen des brevets**

(19)

(11) Publication number : **0 484 097 A1**

(12) ## EUROPEAN PATENT APPLICATION

(21) Application number : **91309971.9**

(22) Date of filing : **29.10.91**

(51) Int. Cl.⁵ : **H03L 7/095**

(30) Priority : **31.10.90 JP 292096/90**

(43) Date of publication of application :
**06.05.92 Bulletin 92/19**

(84) Designated Contracting States :
**DE FR GB NL SE**

(71) Applicant : **NEC CORPORATION**
**7-1, Shiba 5-chome Minato-ku**
**Tokyo 108-01 (JP)**

(72) Inventor : **Uriya, Susumu, c/o NEC Corporation**
**7-1, Shiba 5-chome**
**Minato-ku, Tokyo (JP)**

(74) Representative : **Orchard, Oliver John**
**JOHN ORCHARD & CO. Staple Inn Buildings**
**North High Holborn**
**London WC1V 7PZ (GB)**

(54) **Phase comparing circuitry having an unlock alarm generating circuit.**

(57)   The unlock alarm signal generating circuit (80) neglects the output of a phase comparator (40) included therein when it is representative of an unlocked state only for a short period of time. The circuitry prevents an unlock signal from being generated in a locked state or when modulation is effected.

Fig. 2

BACKGROUND OF THE INVENTION

The present invention relates to phase comparing circuitry applicable to a PLL (Phase Locked Loop) frequency synthesizer or similar device and, more particularly, to phase comparing circuitry having an unlock alarm signal generating circuit responsive to phase lock/ unlock information.

Generally, phase comparing circuitry for the above application has a phase comparator 40 for comparing an input signal with a reference signal with respect to phase, and a charge pump circuit for outputting a voltage representative of a locked state or an unlocked state in response to two outputs of the phase comparator. This type of phase comparing circuitry is usually provided with an unlock alarm signal generating circuit for detecting phase lock/unlock information. The unlock alarm signal generating circuit is made up of a NAND gate to which the outputs of the phase comparator are applied, an open drain type n-channel MOS transistor to which the output of the NAND gate is applied, a resistor and a capacitor which are connected to the transistor, and an alarm terminal on which a low level or "L" alarm signal appears in the event of transition to an unlocked state. In a locked state, the two outputs of the phase comparator are each held in a high level of "H".

The conventional phase comparing circuitry having the above construction brings about a problem when, for example, implemented as an LSI (Large Scale Integrated Circuit). Specifically, if the sensitivity of the transistors included in the circuitry is excessively high, the circuitry responds even to the tuning process which is constantly effected in a locked state. Then, the unlock alarm signal generating circuit outputs an alarm despite the locked state, determining that the phase has been unlocked. Another problem is that since the circuitry outputs an unlock signal every time a modulation wave arrives for effecting modulation, whether an alarm from the unlock alarm signal generating circuit is representative of a true unlocked state or whether it is representative of a false or quasiunlocked state due to the modulation wave cannot be determined.

SUMMARY OF THE INVENTION

It is, therefore, an object of the present invention to provide phase comparing circuitry with an unlock alarm signal generating circuit which prevents an unlock signal from being generated in a locked state or when modulation is effected.

Phase comparing circuitry of the present invention comprises a phase comparator for comparing an input signal and a reference signal and, if the input signal is delayed in phase relative to the reference signal, changing the logical level of a first output while, if the input signal is advanced in phase relatively the reference signal, changing the logical level of a second output, an unlock alarm generating circuit for generating an unlock alarm signal in response to the first and second outputs of the phase comparator, and a control device for controlling the unlock alarm generating circuit such that when the logical level of either of the first and second outputs of the phase comparator has changed over a predetermined period of time, the unlock alarm generating circuit neglects the change and does not output the unlock alarm signal.

BRIEF DESCRIPTION OF THE DRAWINGS

The above and other objects, features and advantages of the present invention will become more apparent from the following detailed description taken with the accompanying drawing in which:
    FIG. 1 is a block diagram schematically showing conventional phase comparing circuitry;
    FIG. 2 is a block diagram schematically showing phase comparing circuitry embodying the present invention ; and
    FIG. 3 is a block diagram schematically showing a specific construction of a phase comparator and a control device included in the embodiment.

DESCRIPTION OF THE PREFERRED EMBODIMENT

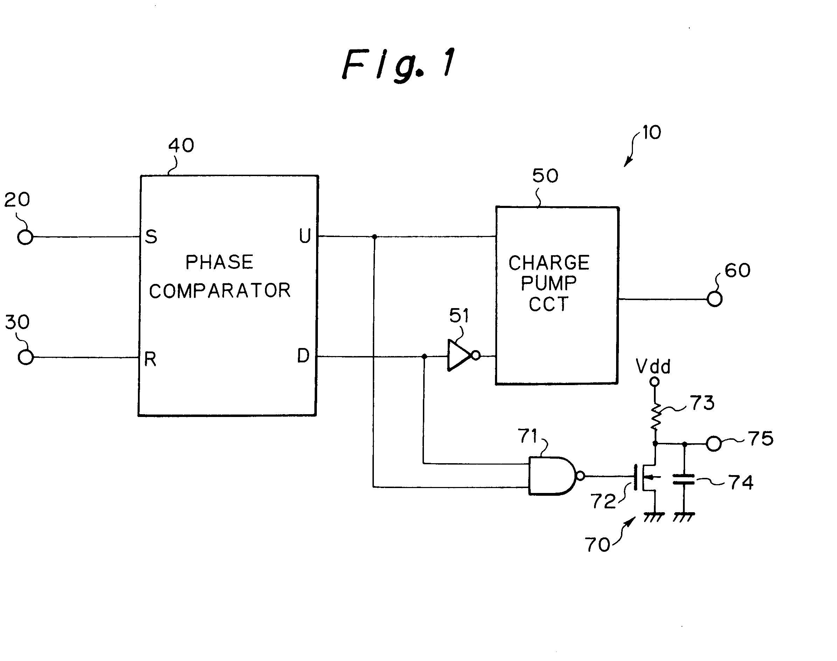

To better understand the present invention, a brief reference will be made to prior art phase comparing circuitry with an unlock alarm signal generating circuit, shown in FIG. 1. As shown, the prior art circuitry, generally 10, has a signal input terminal 20, a reference signal input terminal 30, a phase comparator 40, a charge pump circuit 50, an output terminal 60, and an unlock alarm signal generating circuit 70.

The phase comparator 40 has an S (signal) input connected to the signal input terminal 20, an R (reference signal) input connected to the reference signal input terminal 30, a U (up) output, and a D (down) output. The U output of the phase comparator 40 is directly connected to the U input of the charge pump circuit 50 while the D output of the former is connected to the $\overline{D}$ input of the latter via an inverter 51. A transistor for charging and a transistor for discharging are each connected to one of the U input and $\overline{D}$ input of the charge pump circuit 50, so that a voltage representative of a locked state or an unlocked state appears on the output terminal 60. The U and D outputs of the phase comparator 70 are fed to the unlock alarm signal generating circuit 70 also. The unlock alarm signal generating circuit 70 has a NAND gate 71 for producing NANDing the U and D outputs of the phase comparator 40, an open drain type n-channel MOS transistor 70 to which the output of the NAND gate 71 is fed, and a resistor 73 and a capacitor 74 which are connected to the transistor 72. In an unlocked state, a low level or "L" alarm is fed out via an alarm terminal 75 connected to the junction of the MOS transistor 72, resistor 73 an capacitor 74. When the phase is locked, the phase comparator 40 maintains the U output and D output thereof in a high level or "H".

The conventional circuitry 10 having the above construction brings about a problem when, for example, implemented as an LSI (Large Scale Integrated Circuit). Specifically, if the sensitivity of the transistors included in the circuitry 10 is excessively high, the circuitry 10 responds even to the tuning process which is constantly effected in a locked state. Then, the unlock alarm signal generating circuit 70 outputs an alarm signal despite the locked state, determining that the phase has been unlocked. Another problem is that since the circuitry 10 outputs an unlock signal every time a modulation wave arrives for effecting modulation, whether an alarm from the unlock alarm signal generating circuit 70 is representative of a true unlocked state or whether it is representative of a false unlocked state due to the modulation wave cannot be determined.

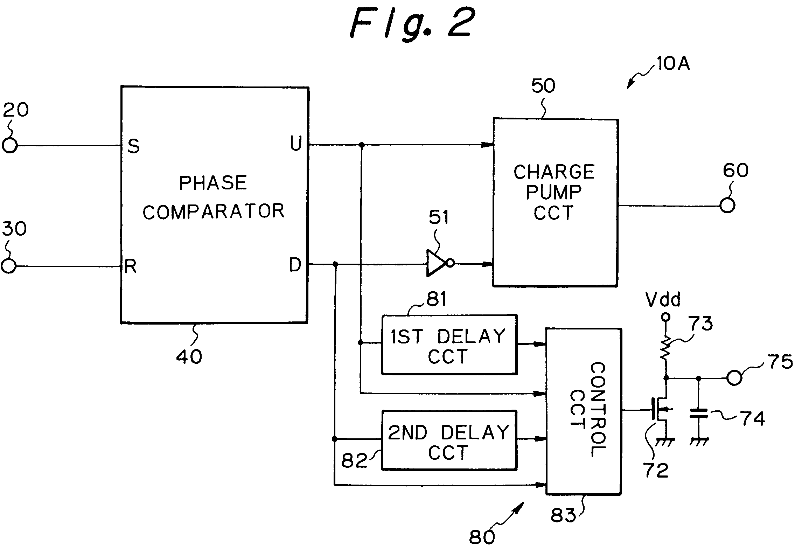

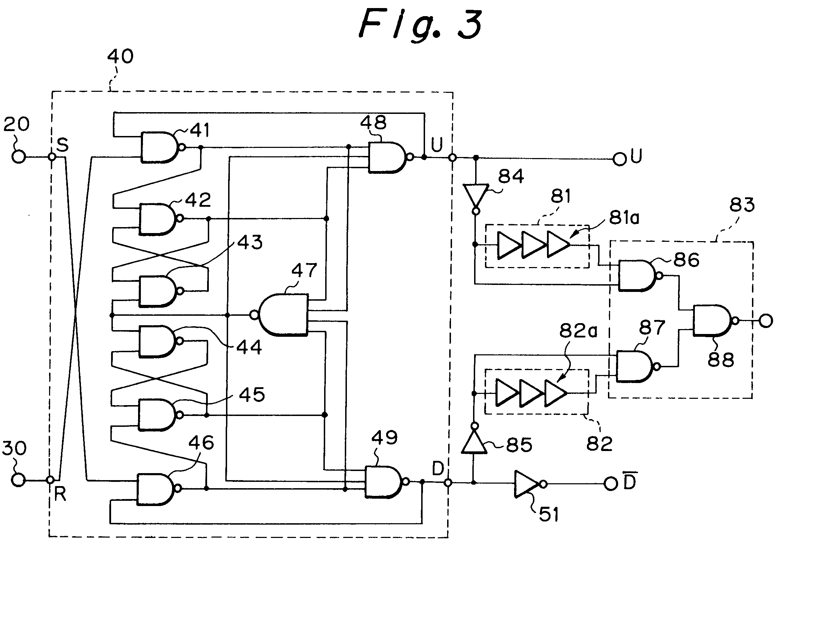

Referring to FIGS. 2 and 3, phase comparing circuitry embodying the present invention is shown which is free from the above-discussed problems. As shown, the phase comparing circuitry, generally 10A, has a control device 80 in place of the NAND gate 71 of the conventional unlock alarm signal generating circuit 70, FIG. 1. For the rest of the construction, the illustrative embodiment is the same as the conventional circuitry 10, and redundant description will be avoided for simplicity. As shown in FIG. 2, the control device 80 has a first delay circuit 81 to which the U output of the phase comparator 40 is applied, a second delay circuit 82 to which the D output of the comparator 40 is applied, and a control circuit 83 to which the outputs of the two delay circuits 81 and 82 and the U and D outputs of the phase comparator 40 are applied. The output of the control circuit 83 is fed to the open drain type n-channel MOS transistor 72. The first and second delay circuits 81 and 82 delay respectively the U output by a period of time $t_1$ and the D output by a period of time $t_2$.

In operation, the first delay circuit 81 neglects unlock information terminating within the period of time $t_1$ while the second delay circuit 82 neglects unlock information terminating within the period of time $t_2$. Hence, the control circuit 83 detects a condition wherein phase deviations lasting more than the time $t_1$ or $t_2$ constantly occur, i.e. , an unlocked state. In response to the resulting output of the control circuit 83, the MOS transistor 72 and the resistor 73 and capacitor 74 connected to the transistor 72 generate an alarm voltage, thereby feeding out an alarm signal via the alarm terminal 75.

FIG. 3 shows a specific construction of the phase comparator 40 and control device 80 included in the embodiment. As shown, the phase comparator 40 is made up of a plurality of NAND gates 41-49 and capable of assuming any one of seven different states. On transition to a locked state, the phase comparator 40 maintains both the U output and the D output thereof in a high level. The first delay circuit 81 is implemented as a single or a plurality of cascaded non-inverters 81a. Likewise, the second delay circuit 82 is constituted by a single or a plurality of cascaded non-inverters 82a. The U and D outputs of the phase comparator 40 are respectively applied to the delay circuits 81 and 82 via inverters 84 and 85 in an inverted state. Therefore, in a locked state, both the first delay circuit 81 and the second delay circuit 82 receive "L" inputs and delivers "L" outputs.

The control circuit 83 has a first NAND gate 86 for NANDing the output of the inverter 84 and the output of the first delay circuit 81 which is the delayed output of the inverter 84, and a second NAND gate 87 for NANDing the output of the inverter 85 and the output of the second delay circuit 82 which is the delayed output of the inverter 85. A third NAND gate 88 produces NAND of the outputs of the NAND gates 86 and 87, and this NAND is fed out as the output of the control circuit 83. In this configuration, on the transition to a locked state, the output of the control circuit 83 goes low with the result that an alarm signal does not appear on the alarm terminal 75.

Assume that the S input of the phase comparator 40 is advanced relative to the R input. Then, the D output of the comparator 40 goes low. At this moment, the second delay circuit 82 does not follow such a signal transition and continuously outputs an "L" signal. Hence, the output of the second NAND gate 87 remains in a high level, so that the output of the control circuit 83 remains in a low level. However, on the elapse of the time $t_2$ after the D output has gone low, the output of the second delay circuit 82 goes high with the result that the second NAND gate 87 goes low. Consequently, the output of the control circuit 83 goes high to render the MOS transistor 72 conductive, causing an "L" alarm to appear on the alarm terminal 75.

Conversely, when the S input of the phase comparator 40 is delayed relative to the R input, the U output of the phase comparator 4 goes low. In this condition, the output of the fist delay circuit 81 remains in a low level until the time $t_1$ expires after the transition of the U output to a low level. Hence, an alarm does not appear on the alarm terminal 75. However, on the elapse of the time $t_1$ after the transition of the U output to a low level, the output of the first delay circuit 81 goes high and causes the output of the first NAND gate 86 to go low. As a result, the output of the control circuit 83 goes high to send an alarm signal via the alarm terminal 75.

It will be seen that the first and second delay circuits 81 and 82 serve to lower the sensitivity in respect of the generation of an unlock signal.

Assume that a reference signal having a frequency fr is modulated by a frequency fm. Then, the second delay circuit 82 delays a signal transition to thereby prevent an unlock signal from being fed out. At this instant, the delay time $t$ should only satisfy a condition:

$$t \geqq \frac{fm}{fr} \times ts$$

where Ts indicates the period of The S input of the phase comparator 13.

The principle described above is also true for a case wherein a signal of frequency fs is modulated by the frequency fm.

While the illustrative embodiment uses two delay circuits 81 and 82 to neglect false or quasiunlocked states, any other suitable circuit arrangement may be used so long as it is capable of neglecting false unlocked states.

In summary, it will be seen that the present invention provides phase comparing circuitry which neglects unlocked states of short durations which may be oututted by a phase comparator. The circuitry is, therefore, immune to unlocked states of short durations which are likely to occur due to the ever increasing operation speed of transistors. This is successful in preventing an unlock signal from being sent out in a locked state. Delay circuits implement the negligence of such false unlocked states, simplifying the construction of the circuitry.

Various modifications will become possible for those skilled in the art after receiving the teachings of the present disclosure without departing from the scope thereof.

## Claims

1. Phase comparing circuitry comprising:

a phase comparator for comparing an input signal and a reference signal and, if said input signal is delayed in phase relative to said reference signal, changing the logical level of a first output while, if said input signal is advanced in phase relatively said reference signal, changing the logical level of a second output;

unlock alarm generating means for generating an unlock alarm signal in response to said first and second outputs of said phase comparator; and

control means for controlling said unlock alarm generating means such that when the logical level of either of said first and second outputs of said phase comparator has changed over a predetermined period of time, said unlock alarm generating means neglects the change and does not output said unlock alarm signal.

2. Circuitry as claimed in claim 1, wherein said control means comprises:

delay means for delaying said first and second outputs of said phase comparator by said predetermined period of time;and

neglecting means for neglecting any change in the logical levels of said first and second outputs of said phase comparator if said logical levels of said first and second outputs are not the same.

3. Circuiry as claimed in claim 2, wherein said delay means comprises:

a first delay circuit for delaying said first output of said phase comparator by a first period of time;

and a second delay circuit for delaying said second output by a second predetermined period of time.

4. Circuitry as claimed in claim 3, wherein said neglecting means comprises:

a first NAND gate for NANDing the delayed output of said first delay circuit and said first output of said phase comparator ; and

a second NAND gate for NANDing the delayed output of said second delay circuit and said second output of said phase comparator ; and

a third NAND gate for NANDing the outputs of said first and second NAND gates.

Fig. 1

# Fig. 2

EP 0 484 097 A1

# Fig. 3

EP 0 484 097 A1

# EP 0 484 097 A1

European Patent
Office

# EUROPEAN SEARCH REPORT

Application Number

EP    91 30 9971

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 302 562 (RTC-COMPELEC) <br> * column 3, line 28 - column 6, line 47; figures 1-3B * | 1-4 | H03L7/095 |
| | ----- | | |

TECHNICAL FIELDS
SEARCHED (Int. Cl.5 )

H03L

The present search report has been drawn up for all claims

| Place of search | Date of completion of the search | Examiner |
|---|---|---|
| THE HAGUE | 19 DECEMBER 1991 | BALBINOT H. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)

8